# EUROPÄISCHE PATENTSCHRIFT

(11) **EP 0 316 616 B1**
(45) Veröffentlichungstag und Bekanntmachung des Hinweises auf die Patenterteilung: **29.03.1995**
(21) Anmeldenummer: 88117681.2
(22) Anmeldetag: 24.10.1988
(51) Int. Cl.: H03M 1/50, H03M 1/14

(54) **Analog-Digital-Umsetzer**
Analog-digital converter
Convertisseur analogique-numérique

(30) Priorität: 19.11.1987 DE 3739209
(43) Veröffentlichungstag der Anmeldung: 24.05.1989
(73) Patentinhaber: SIEMENS AKTIENGESELLSCHAFT, 80333 München (DE)
(72) Erfinder: Pexa, Günther, D-8031 Wörthsee (DE)

(56) Entgegenhaltungen:
- FR-A- 2 246 118
- US-A- 3 281 828
- US-A- 3 778 812

## Beschreibung

Die Erfindung betrifft einen Analog-Digital-Umsetzer nach dem Oberbegriff des Patentanspruchs 1.

Für die Umsetzung von analogen Signalen in digitale Signale sind zahlreiche Verfahren bekannt. Eines dieser Verfahren besteht darin, den Speicherkondensator einer Abtast- und Halteschaltung mit einem konstanten Strom zu entladen und die Zeitdauer zu messen, die benötigt wird, um ein vorgegebenes Potential zu erreichen. Diese Zeitdauer ist ein direktes Maß für den abgetasteten Analogwert. Dies Verfahren führt zu genaueren Ergebnissen, wenn die Entladung des Speicherkondensators zunächst mit einem größeren Konstantstrom bis zu einem ersten Schwellwert und anschließend mit einem konstanten Feinstrom bis zu einem zweiten Schwellwert erfolgt. Bei dieser Schaltungsanordnung müssen die Schwellen eines Komparators umgeschaltet werden. Der Speicherkondensator muß relativ groß sein, um noch mit Konstantströmen einer geeigneten Größenordnung arbeiten zu können. Dies führt jedoch zu Unlinearitäten beim Abtasten des Analogsignals.

Aufgabe der Erfindung ist es, einen nach dem Zählprinzip arbeitenden Analog-Digital-Umsetzer mit hoher Linearität anzugeben.

Diese Aufgabe wird durch die im Patentanspruch 1 angegebenen Merkmale gelöst. Vorteilhafte Ausbildungen sind in den abhängigen Ansprüchen angegeben.

Vorteilhaft bei dieser Schaltungsanordnung ist es, daß der Speicherkondensator der Abtast- und Halteschaltung eine wesentlich geringere Kapazität aufweisen muß, da er nicht mehr durch Konstantstromquellen zur Feststellung der Größe des Abtastwertes entladen werden muß. Diese Aufgabe wird durch den Ladekondensator übernommen. Auch müssen an den Komparator keine unterschiedlichen Vergleichsspannungen mehr angelegt werden, da diese durch die unterschiedlichen Stromwege der Konstantströme automatisch erzeugt werden.

Vorteilhaft ist auch, daß als Konstantstromquellen Differenzverstärker verwendet werden, da diese Temperatur stabil dimensioniert werden können um gleichzeitig die Funktion eines Schalters übernehmen.

Ein Ausführungsbeispiel der Erfindung wird anhand von Figuren näher beschrieben.

Es zeigen
- Fig. 1: einen bekannten Analog-Digital-Umsetzer,
- Fig. 2: einen erfindungsgemäßen Analog-Digital-Umsetzer und
- Fig. 3: ein Ausführungsbeispiel für die Konstantstromquellen.

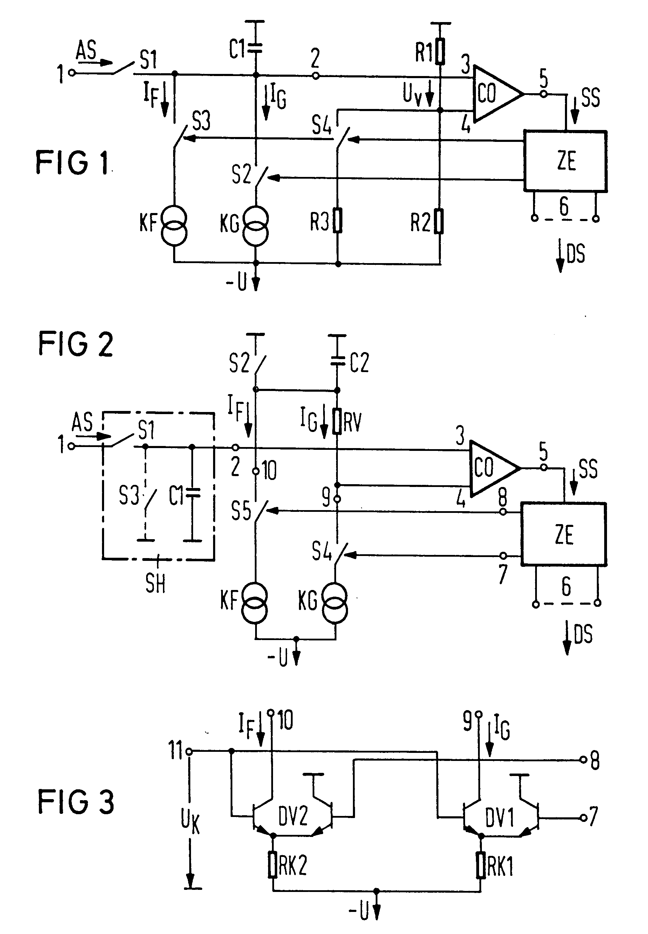

Ein bekannter Analog-Digital-Umsetzer nach Fig. 1 enthält eine Abtast- und Halteschaltung, die aus einem ersten Schalter S1 und einem Speicherkondensator C1 besteht. Der Ausgang 2 der Abtast- und Halteschaltung ist mit einem ersten Eingang 3 eines Komparators C0 verbunden. Eine Konstantstromquelle KG ist an ein Versorgungspotential -U angeschaltet und kann über einen zweiten Schalter S2 mit dem Speicherkondensator C1 verbunden werden. Eine Konstantfeinstromquelle KF ist in derselben Weise über einen dritten Schalter S3 anschaltbar. An einem zweiten Eingang 4 des Komparators C0 ist ein Spannungsteiler R1, R2 angeschaltet, der zwischen Masse und der Versorgungsspannung -U liegt. Über einen vierten Schalter S4 kann ein dritter Widerstand R3 zum zweiten Widerstand R2 des Spannungsteilers parallel geschaltet werden. Über eine an den Ausgang 5 des Komparators C0 angeschaltete Zähleinrichtung ZE werden die Schalter S2 bis S4 betätigt.

Dem Eingang 1 der Abtast- und Halteschaltung wird ein Analogsignal AS zugeführt. Durch kurzzeitiges Schließen des ersten Schalters S1 wird ein Abtastwert in dem Speicherkondensator C1 gespeichert. Anschließend wird über den zweiten Schalter S2 der Speicherkondensator mit einem Konstantstrom I_{G} über die Konstantstromquelle KG entladen, bis der Komparatorausgang 5 ein Steuersignal SS abgibt, das einen Zähler der Zähleinrichtung ZE stoppt. Die Zeitdauer für das Entladen des Speicherkondensators wird im allgemeinen gemessen, indem einem Digitalzähler ein Arbeitstakt mit konstanter Frequenz zugeführt wird. Das Steuersignal SS des Komparators bewirkt außerdem ein Öffnen des zweiten Schalters S2 und ein Schließen des vierten Schalters S4 und des dritten Schalters S3. Am zweiten Eingang 4 des Komparators C0 liegt dann eine (hier negativere) Vergleichsspannung U_{V} an und der Speicherkondensator C1 wird anschließend mit einem geringen Konstantfeinstrom I_{F} der Konstantfeinstromquelle KF entladen und die Endladezeit wieder gemessen, bis der Komparator C0 an seinem Ausgang 5 erneut ein Steuersignal SS abgibt, das den zweiten Zählvorgang - beispielsweise mit einem zweiten Zähler ausgeführt - stoppt. An den Ausgängen 6 der Zähleinrichtung wird ein binär codiertes Datensignal DS abgegeben, das aus beiden Zählvorgängen ermittelt wurde. Die notwendige Steuerlogik ist beispielsweise der Zähleinrichtung zugeordnet. Für die Erzeugung der Vergleichsspannungen U_{V} sind natürlich die unterschiedlichsten Varianten denkbar. Ebenso können natürlich auch die Konstantstromquellen umgeschaltet werden oder die Schalter S2 und S3 durch einen Umschalter ersetzt werden.

In Fig. 2 ist ein Ausführungsbeispiel des erfindungsgemäßen Analog-Digital-Umsetzers dargestellt. Die Abtast- und Halteschaltung SH ist direkt mit dem ersten Eingang 3 des Komparators C0 verbunden. An dem zweiten Eingang 4 des Komparators ist über einen Vorwiderstand RV ein Ladekondensator C2 angeschaltet, dessen zweiter Anschluß an Masse liegt. Parallel zum Ladekondensator liegt ein zweiter Schalter S2. Ein dritter Schalter S3 - strichliert eingezeichnet - kann parallel zum Speicherkondensator C1 geschaltet werden. Die Konstantstromquelle KG ist über einen vierten Schalter S4 direkt an den zweiten Eingang 4 des Komparators C0 anschaltbar. Die Konstantfeinstromquelle KF kann dagegen über einen fünften Schalter S5 direkt an den Ladekondensator C2 angeschaltet werden. Beide Konstantstromquellen sind wieder mit dem Versorgungspotential -U verbunden. Der vierte und der fünfte Schalter werden wiederum von der Zähleinrichtung ZE betätigt, bzw. von einer ihr zugeordneten Steuerlogik. Als Schalter können bipolare Transistoren oder Feldeffekttransistoren verwendet werden.

Durch das Schließen des ersten Schalters S1 wird - wie in der bekannten Ausführungsform nach Fig. 1 - ein Abtastwert im Speicherkondensator C1 gespeichert. Gleichzeitig jedoch ist der Ladekondensator C2 durch kurzzeitiges Schließen des zweiten Schalters S2 entladen worden. Anschließend wird der Ladekondensator C2 durch Schließen des vierten Schalters S4 zunächst mit dem Konstantstrom I_{G} entladen. Hierdurch wird ein Spannungsabfall am Vorwiderstand RV erzeugt, durch den das Potential am zweiten Eingang 4 des Komparators noch negativer wird. Bei Spannungsgleichheit an den Komparatoreingängen (bzw. wenn die Spannung am zweiten Eingang 4 sogar minimal negativer als die am ersten Eingang 3 geworden ist) gibt der Komparator am Ausgang 5 das Steuersignal SS ab, das wieder einen Zählvorgang zur Messung der Entladedauer stoppt, den vierten Schalter S4 öffnet und dafür über den fünften Schalter S5 der Konstantfeinstromquelle KF direkt an den Ladekondensator C2 anschaltet. Durch das Öffnen des vierten Schalters S4 wird das Potential am zweiten Komparatoreingang 4 wieder positiver und der Ladekondensator wird jetzt mit dem Konstantfeinstrom I_{F} weiter entladen, bis erneut Spannungsgleichheit an den Komparatoreingängen herrscht und ein zweites Steuersignal SS am Komparatorausgang einen zweiten Zählvorgang zur Messung der Entladedauer über die Konstantfeinstromquelle beendet, wodurch auch die Analog-Digital-Umsetzung endgültig erfolgt ist.

Die Kapazität des Speicherkondensators C1 kann wesentlich kleiner als die des Ladekondensators C2 sein. Das Kapazitätsverhältnis sollte kleiner als 1:10 sein; es kann aber auch 1:100 betragen oder sogar noch darunter liegen. Die Dimensionierung ist abhängig von der Abtastfrequenz und vom Innenwiderstand der Spannungsquelle des Analogsignals. Bei einem Dimensionierungsbeispiel beträgt die Kapazität des Speicherkondensators 100 pF und die Kapazität des Ladekondensators 10 nF. Durch die geringe Kapazität der Abtast- und Halteschaltung wird eine hohe Linearität erreicht. Durch den Schalter S3 wird dafür gesorgt, daß der Speicherkondensator C1 stets vom selben Potential ausgehend aufgeladen wird. Im allgemeinen kann er entfallen.

In Fig. 3 ist ein Prinzipschaltbild für die Konstantstromquellen dargestellt. Jede Konstantstromquelle besteht aus einem Differenzverstärker DV1 bzw. DV2. Jeweils ein Eingang 11 (Basisanschluß) eines Differenzverstärkers ist mit dem des anderen zusammengeschaltet und liegt an einem konstanten Potential U_{K} an. Die anderen Verstärkereingänge 7 bzw. 8 sind herausgeführt und werden von den entsprechenden Ausgängen der Zähleinrichtung angesteuert. Durch den gemeinsamen Emitterwiderstand RK1 der Transistoren des ersten Differenzverstärkers DV1 und die konstante Spannung U_{K} ist der Konstantstrom I_{G} am Ausgang 9 festgelegt. Der gemeinsame Emitterwiderstand RK2 des zweiten Differenzverstärkers DV2 ist beispielsweise um den Faktor 128 größer als der Emitterwiderstand RK1. Hierdurch ergibt sich ein entsprechend geringerer Konstantfeinstrom I_{F} am Ausgang 10 des zweiten Differenzverstärkers DV2. Die Bezeichnungen der Schaltungspunkte entspricht denen der Fig. 2. Natürlich sind auch hier zahlreiche Varianten für die Schaltungsanordnung und eine Temperaturenkompensation möglich.

## Patentansprüche

1. Analog-Digital-Umsetzer mit einer aus einem ersten Schalter (S1) und einem Speicherkondensator (C1) bestehenden Abtast- und Halteschaltung (SH), deren Ausgang (2) an einen ersten Eingang (3) eines Komparators (C0) angeschaltet ist, mit einer Konstantstromquelle (KG) und einer Konstantfeinstromquelle (KF) sowie mit einer Zähleinrichtung (ZE), die von am Komparatorausgang abgegebenen Steuersignalen (SS) gesteuert werden,
**dadurch gekennzeichnet,**
daß ein Ladekondensator (C2) über einen Vorwiderstand (RV) an einen zweiten Eingang (4) des Komparators (C0) angeschaltet ist, daß die Konstantstromquelle (KG) ebenfalls an den zweiten Eingang (4) des Komparators (C0) anschaltbar ist,
daß die Konstantfeinstromquelle (KF) direkt an den Ladekondensator (C2) anschaltbar ist
und daß ein zweiter Schalter (S2) parallel zum Ladekondensator (C2) geschaltet ist.

2. Analog-Digital-Umsetzer nach Anspruch 1,
**dadurch gekennzeichnet,**
daß ein dritter Schalter (S3) zu dem Speicherkondensator (C1) parallelgeschaltet ist.

3. Analog-Digital-Umsetzer nach Anspruch 1 oder 2,
**dadurch gekennzeichnet,**
daß als Konstantstromquelle (KG) und als Konstantfeinstromquelle (KF) Differenzverstärker (DV1, DV2) vorgesehen sind.

4. Analog-Digital-Umsetzer nach einem der vorhergehenden Ansprüche,
**dadurch gekennzeichnet,**
daß das Verhältnis der Kapazität des Speicherkondensators C1 zur Kapazität des Ladekondensators kleiner als 1:10 ist.

## Claims

1. Analog-digital convertor having a sampling and holding circuit (SH) consisting of a first switch (S1) and a storage capacitor (C1), whose output (2) is connected to a first input (3) of a comparator (CO), having a constant-current source (KG) and a fine-constant-current source (KF) and having a counting device (ZE), which are controlled by control signals (SS) emitted at the comparator output, characterized in that a charging capacitor (C2) is connected to a second input (4) of the comparator (CO) via a series resistor (RV), in that the constant-current source (KG) can likewise be connected to the second input (4) of the comparator (CO), in that the constant-fine-current source (KF) can be connected directly to the charging capacitor (C2), and in that a second switch (S2) is connected in parallel with the charging capacitor (C2).

2. Analog-digital convertor according to Claim 1, characterized in that a third switch (S3) is connected in parallel with the storage capacitor (C1).

3. Analog-digital convertor according to Claim 1 or 2, characterized in that differential amplifiers (DV1, DV2) are provided as constant-current source (KG) and as constant-fine-current source (KF).

4. Analog-digital convertor according to one of the preceding claims, characterized in that the ratio of the capacitance of the storage capacitor C1 to the capacitance of the charging capacitor is smaller than 1:10.

## Revendications

1. Convertisseur analogique-numérique comportant un circuit (SH) d'échantillonnage et de maintien, qui est constitué d'un premier interrupteur (S1) et d'un condensateur (C1) de stockage et dont la sortie (2) est connectée à une première entrée (3) d'un comparateur (CO), une source (KG) de courant constant et une source (KF) de courant constant d'appoint ainsi qu'un dispositif (ZE) compteur, qui est commandé par des signaux (SS) de commande fournis à la sortie du comparateur,
caractérisé en ce que
un condensateur (C2) de charge est connecté par une résistance (RV) série à une seconde entrée (4) du comparateur (CO),
la source (KG) de courant constant est susceptible d'être connectée également à la seconde entrée (4) du comparateur (CO),
la source (KF) de courant constant d'appoint est susceptible d'être connectée directement au condensateur (C2) de charge
et un second interrupteur (S2) est branché en parallèle au condensateur (C2) de charge.

2. Convertisseur analogique-numérique selon la revendication 1,
caractérisé en ce que
un troisième interrupteur (S3) est branché en parallèle au condensateur (C1) de stockage.

3. Convertisseur analogique-numérique suivant la revendication 1 ou 2,
caractérisé en ce que
il est prévu comme source (KG) de courant constant et comme source (KF) de courant constant d'appoint des amplificateurs (DV1, DV2) différentiels.

4. Convertisseur analogique-numérique suivant l'une des revendications précédentes,
caractérisé en ce que
le rapport de la capacité du condensateur (C1) de stockage sur la capacité du condensateur de charge est plus petit que 1:10.
